# EUROPÄISCHE PATENTSCHRIFT

(11) **EP 3 729 213 B1**
(45) Veröffentlichungstag und Bekanntmachung des Hinweises auf die Patenterteilung: **09.02.2022**
(21) Anmeldenummer: 18833596.2
(22) Anmeldetag: 20.12.2018
(51) Int. Cl.: G06N 3/08, G05B 19/042, G05B 17/02, G06K 9/62, G06K 9/00

(54) **VERHALTENSMODELL EINES UMGEBUNGSSENSORS**
BEHAVIOUR MODEL OF AN ENVIRONMENT SENSOR
MODÈLE DE COMPORTEMENT D'UN CAPTEUR D'ENVIRONNEMENT

(30) Priorität: 22.12.2017 AT 510702017
(43) Veröffentlichungstag der Anmeldung: 28.10.2020
(73) Patentinhaber: AVL List GmbH, 8020 Graz (AT)
(72) Erfinder: SAAD, Kmeid, 83624 Otterfing (DE); PAULWEBER, Michael, 8071 Hausmannstätten (AT)
(74) Vertreter: Hahner, Ralph
(86) Internationale Anmeldenummer: PCT/AT2018/060311
(87) Internationale Veröffentlichungsnummer: WO 2019/119011

(56) Entgegenhaltungen:
- EP-A1- 2 950 175
- US-A1- 2017 109 644
- US-A1- 2017 364 776
- SHUIYING WANG ET AL: "Shader-based sensor simulation for autonomous car testing", 2012 15TH INTERNATIONAL IEEE CONFERENCE ON INTELLIGENT TRANSPORTATION SYSTEMS, 1. September 2012 (2012-09-01), Seiten 224-229, XP055557119, DOI: 10.1109/ITSC.2012.6338904 ISBN: 978-1-4673-3062-6

## Beschreibung

Die Erfindung betrifft ein Verfahren zum Trainieren eines künstlichen neuronalen Netzes zur Simulation eines Umgebungssensors eines Fahrerassistenzsystems. Des Weiteren betrifft die Erfindung ein Verfahren zur Analyse eines solchen Umgebungssensors und ein Verfahren zur Simulation eines solchen Umgebungssensors.

Aufgrund der Komplexität heutiger Kraftfahrzeuge besteht das Bedürfnis, deren Komponenten bei der Entwicklung in einer möglichst frühen Entwicklungsphase gemeinsam testen zu können. Solche Tests des Zusammenspiels verschiedener Komponenten können vor dem Vorliegen eines Prototyps entweder durch einen simulierten Betrieb der Komponenten auf einem Prüfstand erfolgen, oder sogar lediglich durch eine wenigstens teilweise modellbasierte Simulation, oder eine vollständig modellbasierte Simulation. Bei einer solchen modellbasierten Simulation wird der Betrieb wenigstens einer Komponente mittels eines Modells simuliert.

Die modellbasiert simulierten Komponenten werden im Allgemeinen mit einem physikalischen Modell modelliert. Hierfür ist ein recht hohes Abstraktionsniveau notwendig, insbesondere, wenn es sich bei den Komponenten um Sensoren handelt, welche als virtuelle Sensoren in einem Modell abgebildet werden sollen.

Bei einigen Komponenten ist es darüber hinaus schwierig, die exakten Spezifikationen zu erhalten. Insbesondere bei Sensoren, und dort wiederum bei Sensoren, welche zu Fahrerassistenzsystemen gehören oder in diesen verbaut sind, stellen die Anbieter oftmals nicht die nötigen Daten zur Verfügung, welche zur Parametrierung oder sogar zur Bildung eines physikalischen Modells notwendig wären. Vorzugsweise weisen solche Sensoren, insbesondere Umgebungssensoren, eine Sensor-Hardware und eine Datenverarbeitungseinrichtung auf, in welcher Messsignale mittels einem Datenverarbeitungsalgorithmus, vorzugsweise zur Weiterverarbeitung für ein Fahrerassistenzsystem, aufbereitet werden.

Das Dokument US 2009/0112334 A1 betrifft ein Verfahren für ein Steuersystem einer Maschine. Das Verfahren kann das Erstellen eines virtuellen Sensormodells einschließen, welches Zwischenbeziehungen zwischen zumindest einem mittels des Sensors erfassten Parameters und einer Vielzahl von gemessenen Parametern in Bezug auf die Maschine charakterisiert.

Das Dokument US 2017/0109644 A1 betrifft Systeme, Verfahren und Vorrichtungen zur Sensorfusion. Ein System zur Sensorfusion umfasst einen oder mehrere Sensoren, eine Modellkomponente und eine Inferenzkomponente. Die Inferenzkomponente ist konfiguriert, um Hindernisse in der Nähe eines Fahrzeugs basierend auf den Sensordaten und dem Modell unter Verwendung eines Algorithmus für gewichtete Integrale und Summen durch Hashing (WISH) zu erkennen und zu verfolgen.

Das Dokument EP 2 950 175 A1 betrifft ein Verfahren zum Testen eines Steuergerätes, bei dem über eine Netzwerkverbindung Sensordaten übertragen werden, welche mittels einer Datenverarbeitungsanlage durch Simulation berechnet werden.

Das Dokument US 2017/0364776A1 betrifft ein Modell für maschinelles Lernen, bei dem ein Szenario definiert wird, das Fahrzeugmodelle und eine typische Fahrumgebung enthält. Dem Szenario wird ein Modell eines Subjektfahrzeugs hinzugefügt und die simulierten Ausgaben der Sensoren, die das Szenario wahrnehmen, werden in einen Algorithmus für maschinelles Lernen eingegeben, der ein Modell trainiert.

Es ist eine Aufgabe der Erfindung, ein Verfahren bereitzustellen, mittels welchem die Simulation eines Umgebungssensors eines Fahrerassistenzsystems verbessert werden kann. Insbesondere ist es eine Aufgabe der Erfindung, den Betrieb eines Sensors so genau simulieren zu können, dass die von dem Simulationsmodell ausgegebenen Daten sich für virtuelle Testfahrten zur Erprobung eines virtuellen oder realen Fahrerassistenzsystems eignen.

Diese Aufgabe wird gelöst durch ein Verfahren zum Trainieren eines künstlichen neuronalen Netzes nach Anspruch 1, ein Verfahren zur Analyse eines Umgebungssensors nach Anspruch 2, ein Verfahren zur Simulation eines Umgebungssensors nach Anspruch 4 sowie durch eine Vorrichtung zum Trainieren eines künstlichen neuronalen Netzes nach Anspruch 10, eine Vorrichtung zur Analyse eines Umgebungssensors eines Fahrerassistenzsystems nach Anspruch 11 und eine Vorrichtung zur Simulation eines Umgebungssensors eines Fahrerassistenzsystems nach Anspruch 12. Vorteilhafte Ausgestaltungen werden in den Unteransprüchen beansprucht. Die Lehre der Ansprüche wird ausdrücklich zum Bestandteil der Beschreibung gemacht.

Ein erster Aspekt der Erfindung betrifft ein Verfahren zum Trainieren eines künstlichen neuronalen Netzes zur Simulation eines Umgebungssensors eines Fahrerassistenzsystems, vorzugsweise folgende Arbeitsschritte aufweisend:
Einlesen von Verkehrsszenarien einer Testfahrt;
Ableiten von Testfahrtdaten und der von dem Umgebungssensor auszugebenden Sensordaten aus den Verkehrsszenarien;
Erzeugen eines Datenstroms, insbesondere eines Bildstroms, welcher die Verkehrsszenarien aus der Perspektive des Umgebungssensors abbildet;
Ausgeben des Datenstroms in der Weise, dass der Umgebungssensor auf der Grundlage des Datenstroms Sensordaten erzeugen kann und an einer Datenschnittstelle bereitstellen kann, an welcher auch die Testfahrtdaten und die auszugebenden Sensordaten bereitgestellt werden; und
Einlesen der bereitgestellten Daten in das künstliche neuronale Netz.

Ein zweiter Aspekt der Erfindung betrifft ein entsprechendes System zum Trainieren eines künstlichen neuronalen Netzes zur Simulation eines Umgebungssensors eines Fahrerassistenzsystems, vorzugsweise aufweisend:
eine Schnittstelle zum Einlesen von Verkehrsszenarien einer Testfahrt;
Mittel zum Ableiten von Testfahrtdaten und der von dem Umgebungssensor auszugebenden Sensordaten aus den Verkehrsszenarien;
Mittel, insbesondere eine Grafikkarte, zum Erzeugen eines Datenstroms, insbesondere eines Bildstroms, welcher die Verkehrsszenarien aus der Perspektive des Umgebungssensors abbildet;
eine Schnittstelle, insbesondere ein Display, zum Ausgeben des Datenstroms in der Weise, dass der Umgebungssensor auf der Grundlage des Datenstroms Sensordaten erzeugen kann; und
eine Datenschnittstelle an welcher die erzeugten Sensordaten, die Testfahrtdaten und die auszugebenden Sensordaten dem künstlichen neuronalen Netz bereitgestellt werden können.

Ein dritter Aspekt der Erfindung betrifft ein Verfahren zur Analyse eines Umgebungssensors eines Fahrerassistenzsystems, vorzugsweise folgende Arbeitsschritte aufweisend:
Einlesen von Verkehrsszenarien einer Vielzahl von Testfahrten;
Ableiten von Testfahrtdaten und der von dem Umgebungssensor auszugebenden Sensordaten aus den Verkehrsszenarien;
Erzeugen eines Datenstroms, insbesondere eines Bildstroms, welcher die Verkehrsszenarien aus der Perspektive des Umgebungssensors abbildet;
Ausgeben des Datenstroms an den Umgebungssensor, welcher auf der Grundlage des Datenstroms Sensordaten erzeugt;
Durchführen einer Ausgleichsrechnung mittels eines künstlichen neuronalen Netzes auf der Grundlage der Testfahrtdaten, der auszugebenden Sensordaten und der durch den Umgebungssensor erzeugten Sensordaten; und
Anwenden eines Simulationsmodells, welches auf der Ausgleichsrechnung basiert, wobei das Simulationsmodell eingerichtet ist, Sensordaten auf der Grundlage von einem Datenstrom einer Testfahrt zu simulieren und auszugeben.

Ein vierter Aspekt der Erfindung betrifft ein entsprechendes System zur Analyse eines Umgebungssensors eines Fahrerassistenzsystems, vorzugsweise aufweisend:
eine Schnittstelle zum Einlesen von Verkehrsszenarien einer Vielzahl von Testfahrten;
Mittel zum Ableiten von Testfahrtdaten und der von dem Umgebungssensor auszugebenden Sensordaten aus den Verkehrsszenarien;
Mittel, insbesondere eine Grafikkarte, zum Erzeugen eines Datenstroms, insbesondere eines Bildstroms, welcher die Verkehrsszenarien aus der Perspektive des Umgebungssensors abbildet;
eine Schnittstelle, insbesondere ein Display, zum Ausgeben des Datenstroms an den Umgebungssensor, welcher auf der Grundlage des Datenstroms Sensordaten erzeugt; Mittel zum Durchführen einer Ausgleichsrechnung mittels eines künstlichen neuronalen Netzes auf der Grundlage der Testfahrtsimulationsdaten, der auszugebenden Sensordaten und der durch den Umgebungssensor erzeugten Sensordaten;
Mittel zum Bestimmen von Sensordaten mittels eines Simulationsmodells, welches auf der Ausgleichsrechnung basiert, wobei das Simulationsmodell eingerichtet ist, Sensordaten auf der Grundlage von einem Datenstrom, insbesondere Bildstrom, einer beliebigen Testfahrt zu simulieren; und
eine Datenschnittstelle zum Ausgeben der mittels des Simulationsmodells bestimmten Sensordaten.

Ein fünfter Aspekt der Erfindung betrifft ein Verfahren zur Simulation eines Umgebungssensors eines Fahrerassistenzsystems, vorzugsweise folgende Arbeitsschritte aufweisend:
Erfassen eines Datenstroms, welcher eine Testfahrt aus der Perspektive des Umgebungssensors abbildet;
Bestimmen von Sensordaten mittels eines Simulationsmodells, welches eingerichtet ist, Sensordaten auf der Grundlage von einem Datenstrom der Testfahrt zu simulieren, wobei das Simulationsmodell auf einer Ausgleichsrechnung mittels eines künstlichen neuronalen Netzes auf der Grundlage von Testfahrtdaten und Datenströmen einer Vielzahl von verschiedenen Testfahrten sowie von bei diesen Testfahrten durch den Umgebungssensor erzeugten Sensordaten beruht; und
Ausgeben der mittels des Simulationsmodells bestimmten Sensordaten.

Ein sechster Aspekt der Erfindung betrifft ein entsprechendes System zur Simulation eines Umgebungssensors eines Fahrerassistenzsystems, vorzugsweise aufweisend:
eine Schnittstelle, insbesondere eine Kamera, zum Erfassen eines Datenstroms, welcher
eine Testfahrt aus der Perspektive des Umgebungssensors abbildet;
Mittel zum Bestimmen von Sensordaten mittels eines Simulationsmodells, welches eingerichtet ist, Sensordaten auf der Grundlage von einem Datenstrom einer beliebigen Testfahrt zu simulieren, wobei das Simulationsmodell auf einer Ausgleichsrechnung mittels eines künstlichen neuronalen Netzes auf der Grundlage von Testfahrtdaten und Datenströmen einer Vielzahl von verschiedenen Testfahrten sowie von bei diesen Testfahrten (R) durch den Umgebungssensor erzeugten Sensordaten beruht; und
eine Datenschnittstelle zum Ausgeben der mittels des Simulationsmodells bestimmten Sensordaten.

Ein Umgebungssensor im Sinne der Erfindung ist vorzugsweise eingerichtet, Informationen über eine Umgebung eines Fahrzeugs, welche das Fahrerassistenzsystem aufweist, zu erfassen. Vorzugsweise betrifft diese Information wenigstens eine Eigenschaft aus der nachfolgenden Gruppe von Eigenschaften: Temperatur, Bilder, insbesondere optische, Infrarot- oder Radar-Bilder, Distanzen, Feuchtigkeit, Luftdruck, Staudruck, elektromagnetische Strahlung, radioaktive Strahlung, Helligkeit, Sichtweite.

Der Umgebungssensor ist hierbei vorzugsweise als Hardware und/oder Software ausgebildet. Vorzugsweise weist der Umgebungssensor einen Datenverarbeitungsalgorithmus auf. Alternativ oder zusätzlich weist der Umgebungssensor eine Vorrichtung zum Erfassen der Informationen auf.

Testfahrtdaten im Sinne der Erfindung sind vorzugsweise Umweltdaten in Bezug auf das Fahrzeug, welches das Fahrerassistenzsystem trägt. Die Umweltdaten sind hierbei jene Eigenschaften der Umwelt, welche vorzugsweise nicht von dem zu simulierenden Umgebungssensor erfasst werden. Alternativ oder zusätzlich umfassen die Testfahrtdaten statische Daten, welche die Dimensionen sowie Eigenschaften des Fahrzeugs, aber insbesondere auch die Dimension der Straße, aufweisen. Zusätzlich oder alternativ weisen die Testfahrtdaten sogenannte Egodaten auf, welche die dynamischen Eigenschaften des Fahrzeugs, welches das Fahrerassistenzsystem trägt, wie beispielsweise Blinksignale, Geschwindigkeit, Beschleunigung und/oder Neige-, Gier- oder Rollbewegungen umfasst.

Ein Datenstrom im Sinne der Erfindung enthält vorzugsweise Information. Weiter vorzugsweise ist ein Datenstrom ein optisches Signal, ein elektromagnetisches Signal, ein Feuchtigkeitswert, ein Luftdruckwert, ein Staudruckwert, ein Strahlungswert, ein Temperaturwert oder ein Helligkeitswert. Vorzugsweise betrifft der Datenstrom eine Abfolge von Werten der Information in Abhängigkeit von der Zeit und/oder von einer zurückgelegten Distanz.

Eine Datenschnittstelle im Sinne der Erfindung ist vorzugsweise Teil eines künstlichen neuronalen Netzes oder einer Vorrichtung und/oder eines Computerprogramms, welche das erfindungsgemäße Verfahren jeweils ausführen. Die Datenschnittstelle kann hierbei vorzugsweise aus mehreren Teilschnittstellen bestehen, welche jeweils durch Hardware und/oder Software ausgebildet sind.

Ein Mittel im Sinne der Erfindung ist vorzugsweise hard- und/oder softwaretechnisch ausgebildet sein, insbesondere eine, vorzugsweise mit einem Speicher- und/oder Bussystem daten- bzw. signalverbundene, insbesondere digitale, Verarbeitungs-, insbesondere Mikroprozessor-Einheit (CPU) und/oder ein oder mehrere Programme oder Programm-Module aufweisen. Die CPU kann dazu ausgebildet sein, Befehle, die als ein in einem Speichersystem abgelegtes Programm implementiert sind, abzuarbeiten, Eingangssignale von einem Datenbus zu erfassen und/oder Ausgangssignale an einen Datenbus zu geben. Ein Speichersystem kann ein oder mehrere, insbesondere verschiedene, Speichermedien, insbesondere optische, magnetische, Festkörper- und/oder andere nicht-flüchtige Medien, aufweisen. Das Programm kann derart beschaffen sein, dass es die hier beschriebenen Verfahren verkörpert bzw. auszuführen imstande ist, dass die CPU die Schritte solcher Verfahren ausführen kann und damit insbesondere einen Wert einer Zielgröße in Bezug auf die Robustheit wenigstens eines Fahrzeugs einer Fahrzeuggattung bestimmen kann.

Ein Verkehrsszenario im Sinne der Erfindung ist vorzugsweise eine Konstellation von Verkehrsteilnehmern und Objekten im Bereich und Umfeld einer Fahrbahn, insbesondere einer Straße. Ein Verkehrsszenario besteht weiter vorzugsweise aus einer oder mehrerer Verkehrsszenen, welche zeitlich nacheinander abfolgen.

Die Erfindung beruht insbesondere auf dem Ansatz, die Sensoren eines Fahrerassistenzsystems durch sogenannte Verhaltensmodelle (Englisch: behavioral model) nachzubilden. Solche Verhaltensmodelle basieren im Allgemeinen auf Methoden des tiefgehenden Lernens (Englisch: deep learning).

Mittels eines Simulationsmodells, welches auf einem Verhaltensmodell beruht, ist es insbesondere möglich, einen Sensor zu modellieren, ohne dessen genaue Spezifikationen zu kennen. Dies gilt sowohl für die Spezifikationen in Bezug auf etwaige Hardwarekomponenten des Sensors als auch für einen etwaig vorhandenen Datenverarbeitungsalgorithmus, welcher vorzugsweise Teil des Umgebungssensors, insbesondere einer Datenverarbeitungseinrichtung des Umgebungssensors, ist. Um besonders exakte Ergebnisse der Simulation für den Sensor zu erhalten, wird das Simulationsmodell mit Datenströmen trainiert, welches die jeweilige Testfahrt aus der Sicht bzw. Perspektive des jeweiligen Umgebungssensors wiedergibt. Des Weiteren wird das Modell mit Testdaten und mit den tatsächlich von dem Sensor auszugebenden Sensordaten versorgt.

Die von dem zu simulierenden Umgebungssensor auszugebenden Sensordaten werden ebenfalls aus den Verkehrsszenarien der jeweiligen Testfahrt gewonnen. Bei einer simulierten bzw. virtuellen Testfahrt können diese Daten bereits von der Simulationsumgebung bereitgestellt werden, bei Verkehrsszenarien auf der Grundlage einer realen Testfahrt können Auswertealgorithmen oder auch eine manuelle menschliche Auswertung zum Einsatz kommen.

Das künstliche neuronale Netz kann durch Einlesen der Eingangsgrößen (Testfahrtdaten, ausgegebene Sensordaten) und der auszugebenden Ausgangsgrößen (auszugebende Sensordaten) nach und nach aufgebaut werden.

Die erfindungsgemäße Vorgehensweise zeichnet sich insbesondere dadurch aus, dass das Sensormodell mit realistischen Daten in Bezug auf den jeweiligen Einbauort des Umweltsensors trainiert werden kann.

Das Simulationsmodell auf der Grundlage von künstlichen neuronalen Netzen hat darüber hinaus den Vorteil, dass dieses das tatsächliche Verhalten eines echten Sensors in Echtzeit nachbilden kann. Testfahrten können somit für das Fahrerassistenzsystem auf der Grundlage der Daten des simulierten Umgebungssensors in Echtzeit ausgeführt werden.

Das Simulationsmodell auf der Grundlage von künstlichen neuronalen Netzen hat darüber hinaus den Vorteil, dass es das Verhalten bzw. eine Veränderung der Ausgabe des zu simulierenden Umgebungssensors bei gleichem Verkehrsszenario aber Störungen wie unterschiedlichen Umweltbedingungen, insbesondere Witterungsbedingungen und/oder Mängel der Hardware des Umgebungssensors (US), z.B. eine Aberration einer Optik oder auch eines Beschlagens der Optik mit Feuchtigkeit oder Verschmutzung der Optik, realitätsgetreu simulieren kann. Erzeugt ein Sensor beispielsweise eine Objektliste, so kann die Objektliste bei Auftreten solcher Störungen wesentlich von einer Objektliste abweichen, welche ohne das Auftreten dieser Störungen erzeugt würde. Ähnlich verhält es sich mit Veränderungen von Parametern, welche für die Wahrnehmung der Verkehrsszenarien durch den zu simulierenden Umgebungssensor relevant sind, von dem zu simulierenden Umgebungssensor selbst aber nicht erfasst werden.

Dies wird erfindungsgemäß erreicht, indem das Simulationsmodell mittels der zu einem Zeitpunkt auszugebenden Sensordaten, d.h. einer idealen Wahrnehmung der Fahrszenarien durch den Umgebungssensor, der zu dem Zeitpunkt ausgegebenen Sensordaten, d.h. der tatsächlich vorliegenden Wahrnehmung der Fahrszenarien durch den Umgebungssensor, und der Testfahrdaten trainiert wird.

Ein siebter Aspekt der Erfindung betrifft ein Verfahren zur Analyse eines Fahrerassistenzsystems, wobei das Fahrerassistenzsystem während einer realen oder simulierten Testfahrt mit dem mittels eines Verfahrens nach dem ersten, dritten oder fünften Aspekt der Erfindung ausgegebenen Sensordaten sowie mit Daten anderer virtueller oder realer Sensoren, welche vorzugsweise innerhalb eines Datennetzwerks, insbesondere Kennnetzwerks, eines Fahrzeugs zur Verfügung stehen, gespeist wird. Mittels dieses Verfahrens kann die Leistung des Gesamtsystems aus Fahrerassistenzsystem sowie simuliertem Umgebungssensor und gegebenenfalls weiteren Sensoren getestet werden. Das Zusammenführen der Daten des simulierten Sensors sowie weiterer simulierter oder realer Sensoren kann insbesondere mittels Sensor-Fusion vorgenommen werden.

In einer vorteilhaften Ausgestaltung des Verfahrens gemäß dem ersten und dritten Aspekt der Erfindung werden die Arbeitsschritte mit verschiedenen Testfahrten so lange wiederholt, bis das künstliche neuronale Netz die Funktion des Sensors möglichst genau abbildet, insbesondere bis die auszugebenden Daten mit den ausgegebenen Daten zu 95 %, vorzugsweise 98 %, in Bezug auf eine nicht bei der Ausgleichsrechnung berücksichtigte Testfahrt übereinstimmen.

In einer vorteilhaften Ausgestaltung des Verfahrens gemäß dem fünften Aspekt der Erfindung weist dieses des Weiteren den folgenden Arbeitsschritt auf:
Erzeugen eines Datenstroms, insbesondere eines Bildstroms, welcher eine Testfahrt aus Sicht des Umgebungssensors abbildet, insbesondere auf der Grundlage der Verkehrsszenarien.

Entsprechend weist die Vorrichtung zur Simulation eines Umgebungssensors gemäß dem sechsten Aspekt der Erfindung in einer vorteilhaften Ausgestaltung Mittel zum Erzeugen eines Datenstroms, insbesondere eines Bildstroms, auf, welcher eine Testfahrt aus Sicht des Umgebungssensors abbildet, insbesondere auf der Grundlage von Verkehrsszenarien der Testfahrt.

In einer vorteilhaften Ausgestaltung weist das Verfahren nach einem der Aspekte der Erfindung des Weiteren den folgenden Arbeitsschritt auf:
Verschlechtern, insbesondere Verzerren, des Datenstroms, insbesondere des Bildstroms, wobei vorzugsweise Witterungsbedingungen und/oder Mängel der Hardware des Umgebungssensors berücksichtigt werden. Mittels dieser vorteilhaften Ausgestaltung kann die Fähigkeit eines Datenverarbeitungsalgorithmus des Sensors oder auch eines Fahrerassistenzsystems selbst geprüft werden, mit fehlerbehafteten Sensordaten umzugehen bzw. diese im Betrieb zu kompensieren.

In einer weiteren vorteilhaften Ausgestaltung des Verfahrens gemäß einem der Aspekte der Erfindung wird/werden die Testfahrt oder die Testfahrten auf einem Prüfstand oder modellbasiert simuliert oder real durchgeführt, vorzugsweise mittels einer Kombination aus den vorgenannten Möglichkeiten. Auf diese Weise kann der Umgebungssensor bzw. das Fahrerassistenzsystem in jeder Phase eines Entwicklungszyklus getestet werden.

Weitere Vorteile und Merkmale ergeben sich aus den bevorzugten Ausführungsbeispielen, welche nachfolgend in Bezug auf die Figuren beschrieben werden.

Es zeigen wenigstens teilweise schematisch:
- **Fig. 1**: ein Ausführungsbeispiel einer Vorrichtung gemäß dem zweiten Aspekt der Erfindung;
- **Fig. 2**: ein Ausführungsbeispiel eines Verfahrens gemäß dem ersten Aspekt der Erfindung;
- **Fig. 3**: ein Ausführungsbeispiel einer Vorrichtung gemäß dem dritten Aspekt der Erfindung;
- **Fig. 4**: ein Ausführungsbeispiel des Verfahrens gemäß dem dritten Aspekt der Erfindung und ein Ausführungsbeispiel des Verfahrens gemäß dem fünften Aspekt der Erfindung; und
- **Fig. 5**: ein Ausführungsbeispiel der Vorrichtung gemäß dem sechsten Aspekt der Erfindung.

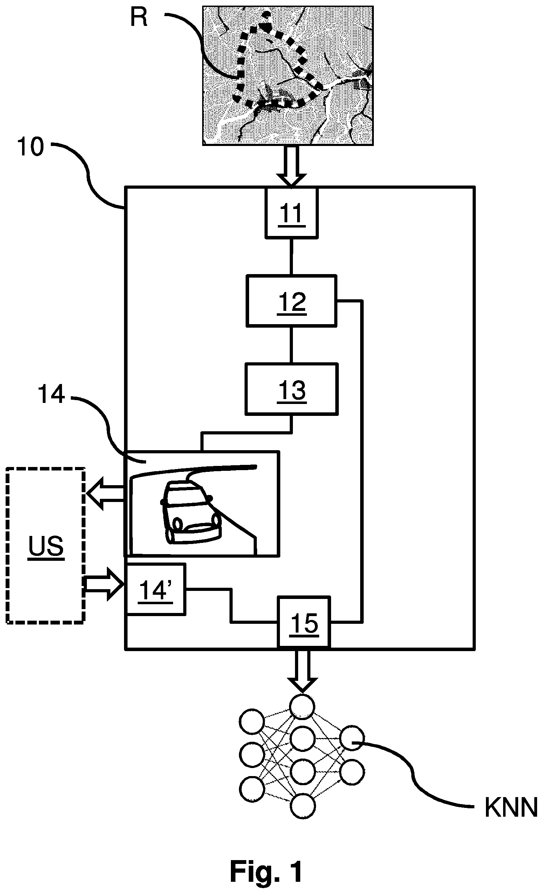

**Fig. 1** zeigt ein erstes Ausführungsbeispiel einer erfindungsgemäßen Vorrichtung zum Trainieren eines künstlichen neuronalen Netzes KNN zur Simulation eines Umgebungssensors US eines Fahrerassistenzsystems.

Die Erfindung wird im Folgenden für alle Ausführungsbeispiele anhand einer optischen Kamera als Umgebungssensor US beschrieben. Grundsätzlich können aber auch andere Komponenten, insbesondere andere (Umgebungs-)Sensoren mittels der beschriebenen Verfahren und Systeme nachgebildet und analysiert werden. Beispielhaft, aber nicht abschließend, seien diesbezüglich Lidar-Sensoren, Radar-Sensoren, Ultraschallsensoren, Temperatursensoren, Feuchtigkeitssensoren, Strahlungssensoren etc. genannt.

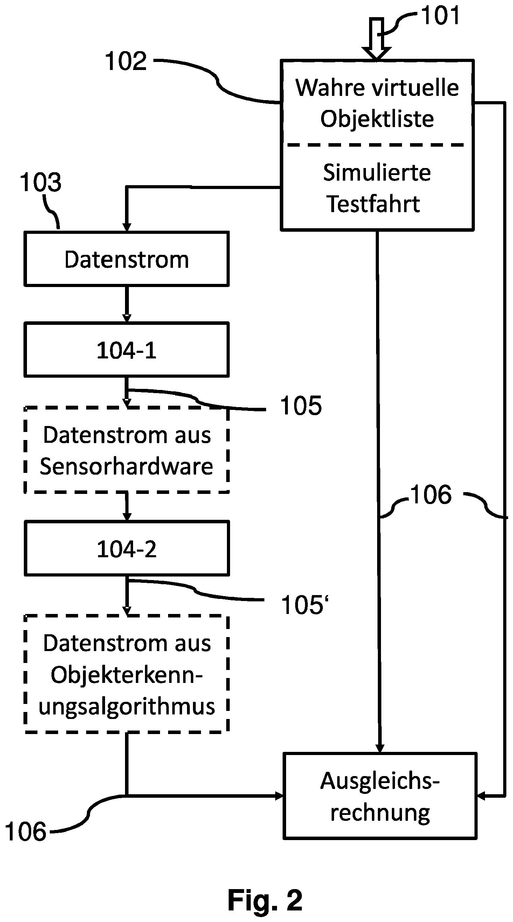

Das entsprechende Verfahren 100, welches mit dem System 10 ausgeführt werden kann, ist in **Fig. 2** dargestellt.

Daten einer Testfahrt R bzw. die auf dieser Testfahrt R angetroffenen Verkehrsszenarien werden dem System 10 bereitgestellt bzw. von dem System 10 eingelesen 101.

Die Testfahrt kann eine simulierte Testfahrt R bzw. simulierte Verkehrsszenarien sein, welche beispielsweise mit der Software CarMaker^{®} der IPG Automotive^{®} erstellt ist. Alternativ können die Testfahrt R bzw. deren Verkehrsszenarien aber auch während eines realen Betriebs eines Fahrzeugs aufgenommen sein.

Aus den Verkehrsszenarien der Testfahrt R werden mittels der Mittel 11 Testfahrtdaten sowie die tatsächlichen, von dem Umgebungssensor US zu erkennenden und auszugebenden "wahre" Sensordaten extrahiert bzw. abgeleitet 102. Werden die Verkehrsszenarien von einer Simulationssoftware, wie CarMaker^{®}, bereitgestellt, so besteht das Extrahieren im Wesentlichen aus dem Identifizieren der für das System 10 bzw. Verfahren 100 notwendigen Testfahrtdaten und jener Daten, welche für den zu simulierenden Umgebungssensor relevant sind.

In Bezug auf eine optische Kamera könnte dies beispielsweise eine zu erstellende Objektliste sein. Eine "wahre" Objektliste kann aus der Simulationssoftware, wie CarMaker^{®}, unmittelbar abgeleitet werden 102. Bei aufgenommenen Verkehrsszenarien realer Testfahrten muss die Anzahl der Objekte im Allgemeinen mittels eines sogenannten Labeling-Werkzeugs bestimmt werden. Dies kann automatisiert erfolgen, allerdings muss im Allgemeinen durch eine Person geprüft werden, ob die Daten korrekt sind.

Die Testfahrtdaten, welche wiederum aus den Verkehrsszenarien abgeleitet werden 102, sind beispielsweise Umweltdaten, also insbesondere Daten anderer Sensoren, wie jener des zu untersuchenden Umgebungssensors US, statische Daten, insbesondere die Dimension des Fahrzeugs sowie der Straße und Ego-Daten, insbesondere dynamische Daten des Fahrzeugs, sowie andere Zustandsdaten des Fahrzeugs, wie beispielsweise Blinken oder auch Aufblenden. Das Ableiten kann hierbei mittels von Mitteln 12 zum Ableiten durchgeführt werden.

Ebenfalls auf der Grundlage der Verkehrsszenarien der Testfahrt R wird mittels Mitteln 13 ein Datenstrom, insbesondere ein Bildstrom, erzeugt 103, welcher die Verkehrsszenarien aus Sicht des Umgebungssensors US abbildet.

Im Falle des Bildstroms kann hierbei vorzugsweise eine handelsübliche Grafikkarte 13 bzw. eine spezielle Grafiksoftware für eine solche Grafikkarte als Mittel 13 zum Einsatz kommen.

Der so erzeugte Bildstrom wird auf einem Display 14 als Schnittstelle an die Kamera US ausgegeben 105.

Optional besteht vor dem Ausgeben die Möglichkeit, den Bildstrom zu verschlechtern, insbesondere Witterungsbedingungen vorzutäuschen 104-1. Hierdurch kann eine Reaktion des Umgebungssensors US bzw. die Qualität der unter diesen Umständen durch den Umgebungssensor US bestimmten Sensordaten erreicht bzw. geprüft werden.

In einer alternativen Ausführungsform wird der Datenstrom, welcher die Verkehrsszenarien aus Sicht des Umgebungssensors US abbildet, unmittelbar an ein Modell des physischen Teils des Sensors, also ein Modell der Sensor-Hardware, ausgegeben. Bei einer optischen Kamera bildet das Modell der Sensor-Hardware, also der Kamera-Hardware, im Wesentlichen eine Optik und einen Bildsensor ab.

Alternativ oder zusätzlich ist es auch möglich, einen Datenstrom aus der Kamera-Hardware oder aus dem Modell der Kamera-Hardware vor der Verarbeitung durch einen Datenverarbeitungsalgorithmus des Umgebungssensors US, im vorliegenden Beispiel ein Objekterkennungsalgorithmus der Kamera, zu verschlechtern 104-2, 204-2, und erst dann an den Objekterkennungsalgorithmus auszugeben 105', 205'. Mögliche Verschlechterungen des Bildstroms oder des Datenstroms, welche durch die Kamera-Hardware oder das Modell der Kamera-Hardware hervorgerufen bzw. simuliert werden können, sind beispielsweise Abbildungsfehler einer Optik oder Fehler oder Verschmutzungen auf einem Bildsensor.

Auf der Grundlage des ausgegebenen Bildstroms bzw. des verschlechterten Bildstroms oder des Datenstroms aus der Sensor-Hardware oder aus dem Modell der Sensor-Hardware erzeugt der Objekterkennungsalgorithmus Sensordaten, welche über eine weitere Schnittstelle 14' wieder in das System 10 eingelesen werden und über eine weitere Datenschnittstelle 15 zusammen mit den abgeleiteten Testfahrtdaten und den tatsächlichen auszugebenden Sensordaten bereitgestellt werden.

Diese Daten, d.h. die Sensordaten, die abgeleiteten Testfahrtdaten und die tatsächlichen auszugebenden Sensordaten, können dann in das künstliche neuronale Netz KNN zum Training desselbigen eingelesen werden 106.

Vorzugsweise werden diese Arbeitsschritte mit verschiedenen Testfahrten und daher mit jeweils anderen Verkehrsszenarien zum Training des künstlichen neuronalen Netzes KNN so lange wiederholt, bis das künstliche neuronale Netz KNN die Funktion des Umgebungssensors US möglichst genau abbildet.

Die Genauigkeit kann beispielsweise bestimmt werden, indem das trainierte künstliche neuronale Netz KNN mit Daten nicht zum Trainieren eingesetzter unbekannter Testfahrten R' konfrontiert wird und auf der Grundlage dieser Daten die tatsächlich auszugebenden Sensordaten mit den durch das künstliche neuronale Netz KNN erzeugten Sensordaten verglichen werden. Vorzugsweise sollten die auszugebenden Sensordaten und die mittels des künstlichen neuronalen Netzes KNN erzeugten Sensordaten mit einer Genauigkeit von wenigstens 95 %, vorzugsweise mehr als 98 %, übereinstimmen, bevor das Verfahren 100 beendet wird.

Mittels des künstlichen neuronalen Netzes KNN wird eine Ausgleichsrechnung durchgeführt, deren Ergebnis ein Simulationsmodell des Umgebungssensors US ist. Je nachdem, ob die Sensor-Hardware, im vorliegenden Ausführungsbeispiel also die Kamera-Hardware, dabei zum Training des künstlichen neuronalen Netzes KNN eingesetzt wurde oder durch ein Modell der Sensor-Hardware simuliert wurde, bildet das künstliche neuronale Netz KNN den gesamten Umgebungssensor US oder eben nur einen Datenverarbeitungsalgorithmus des Umgebungssensors US, insbesondere einen Objekterkennungsalgorithmus der Kamera, ohne die Sensor-Hardware ab.

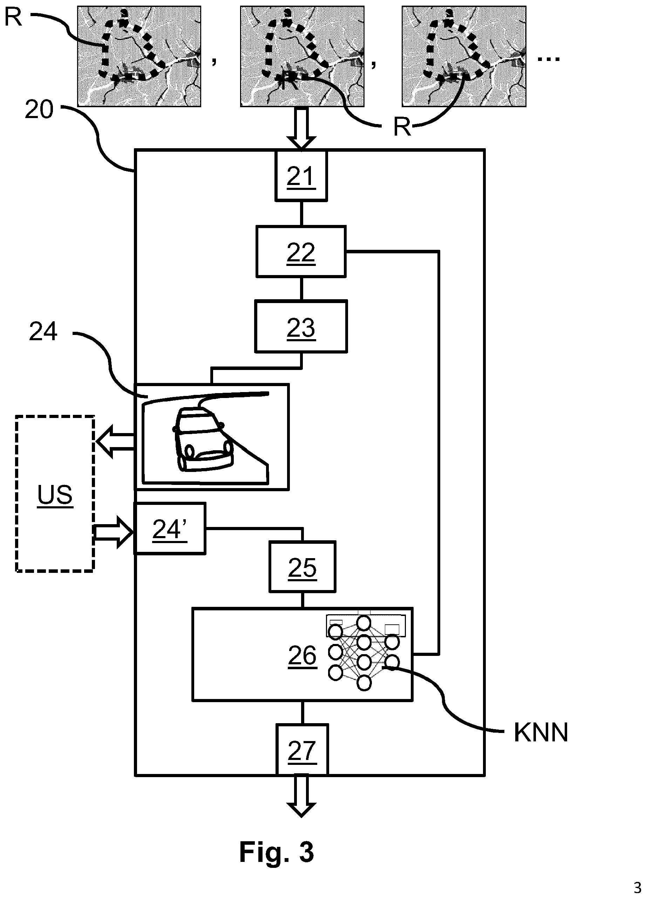

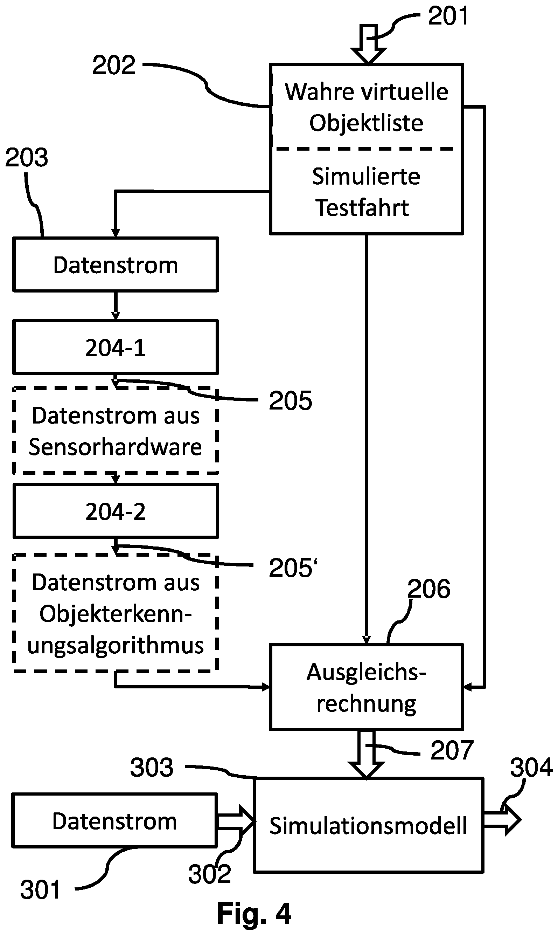

Anhand der **Figuren 3** **und** **4** wird ein System 20 und ein mittels dieses Systems 20 ausführbares Verfahren 200 erläutert, welche zur Analyse eines Umgebungssensors US eines erfindungsgemäßen Fahrerassistenzsystems dienen.

Die Figuren 3 und 4 betreffen insbesondere das Verfahren des dritten Aspekts der Erfindung und das entsprechende System gemäß dem vierten Aspekt der Erfindung.

Im Wesentlichen entspricht die Vorgehensweise jener, welche in Bezug auf die Figuren 1 und 2 zu dem ersten und zweiten Aspekt der Erfindung dargestellt wurde.

In das System zur Analyse des Umgebungssensors US eines Fahrerassistenzsystems werden über eine Schnittstelle 21 Verkehrsszenarien einer Vielzahl von Testfahrten eingelesen 201. Testfahrtdaten und von dem Umgebungssensor US auszugebende Sensordaten werden mittels Mitteln 22 zum Ableiten aus den Verkehrsszenarien abgeleitet 202.

Eine Grafikkarte 23 erzeugt einen Bildstrom, welcher die Testfahrten aus Sicht des Umgebungssensors US abbildet auf der Grundlage der Verkehrsszenarien. Mittels einer Schnittstelle 24, 24', insbesondere einem Display, wird der Bildstrom an den Umgebungssensor US ausgegeben, welcher auf der Grundlage des Datenstroms Sensordaten erzeugt 205; 205'.

Auch in einer alternativen Ausführungsform des Verfahrens 200 ist es möglich, den Datenstrom, welcher die Verkehrsszenarien aus Sicht des Umgebungssensors US abbildet, unmittelbar an ein Modell des physischen Teils des Sensors, also ein Modell der Sensor-Hardware, auszugeben. Bei einer optischen Kamera US bildet das Modell der Sensor-Hardware, also der Kamera-Hardware, im Wesentlichen eine Optik und einen Bildsensor ab.

Auch in dem Verfahren 200 ist es möglich, den Bildstrom oder Datenstrom zu verschlechtern, entweder durch simulierte Umweltbedingungen 204-1, bevor der Bildstrom oder Datenstrom von einer Kamera-Hardware bzw. einem Modell der Kamera-Hardware erfasst wird, oder aber durch simulierte Fehler der Kamera-Hardware oder des Modells der Kamera-Hardware selbst 204-2, bevor der Bild- bzw. Datenstrom einem Objekterkennungsalgorithmus zugeführt wird.

Schließlich werden sämtliche Daten, d.h. die Sensordaten, die abgeleiteten Testfahrtdaten und die tatsächlichen auszugebenden Sensordaten, einer Ausgleichsrechnung, welche insbesondere auf einemkünstlichen neuronalen Netz KNN basiert, zugeführt, wobei die Ausgleichsrechnung vorzugsweise mit entsprechenden Mitteln 25 zur Datenverarbeitung durchgeführt wird 206. Auf diese Weise kann vorzugsweise das künstliche neuronale Netz KNN trainiert werden.

Im Unterschied zum System 10 weist das System 20 nunmehr noch Mittel 26 zum Bestimmen von Sensordaten mittels eines Simulationsmodells auf. Wird dieses Simulationsmodell, welches vorzugsweise das trainierte künstliche neuronale Netz KNN enthält, angewendet 207, so können Sensordaten des Umgebungssensors auf der Grundlage eines Datenstroms durch eine beliebige Testfahrt R' simuliert werden. Diese simulierten Sensordaten können schließlich über eine Datenschnittstelle 27 ausgegeben werden. Auch in diesem Ausführungsbeispiel bildet das Simulationsmodell den gesamten Sensor oder eben nur einen Datenverarbeitungsalgorithmus, insbesondere Objekterkennungsalgorithmus, ohne die Sensor-Hardware ab - je nachdem, ob die Sensor-Hardware, im vorliegenden Ausführungsbeispiel also die Kamera-Hardware, zur Erzeugung der Sensordaten eingesetzt wurde oder dabei durch ein Modell der Sensor-Hardware simuliert wurde.

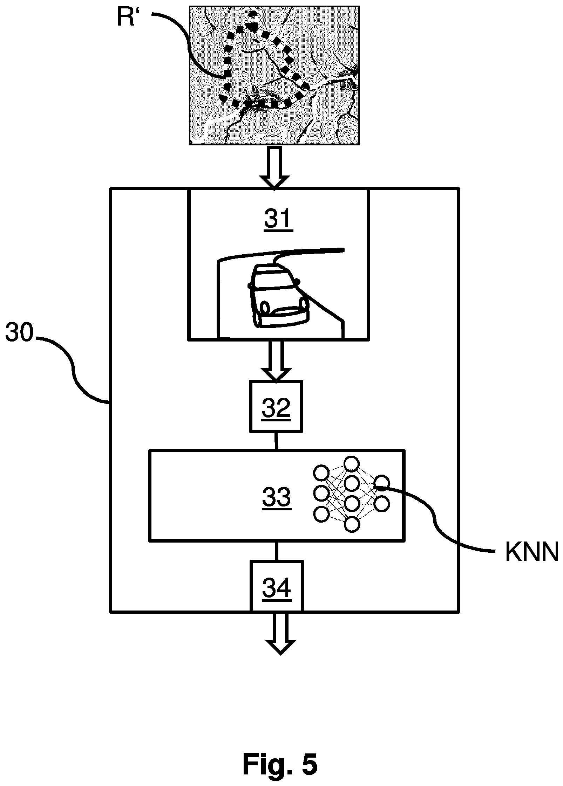

Ebenfalls anhand der Fig. 4 und der **Fig. 5** werden schließlich ein Verfahren zur Simulation eines Umgebungssensors eines Fahrerassistenzsystems gemäß dem fünften Aspekt der Erfindung und ein entsprechendes System 30 gemäß dem sechsten Aspekt der Erfindung beschrieben.

Wie in Fig. 5 gezeigt, umfasst das System 30 Mittel 31 zum Erzeugen eines Bildstroms oder Datenstroms, welcher Testfahrten aus Sicht des Umgebungssensors US abbildet 301.

Dieser Bildstrom oder Datenstrom wird vorzugsweise mittels einer Kamera oder einer Datenschnittstelle 32 erfasst 302. Die Information des erfassten Bildstroms oder Datenstroms wird einem Simulationsmodell zugeführt.

Auf der Grundlage des erfassten Bildstroms oder Datenstroms werden mittels Mitteln 33 zur Datenverarbeitung Sensordaten durch das Simulationsmodell simuliert, wobei das Simulationsmodell vorzugsweise auf einer Ausgleichsrechnung mittels eines künstlichen neuronalen Netzes KNN auf der Grundlage von Testfahrtdaten und Datenströmen einer Vielzahl von verschiedenen Testfahrten sowie von bei diesen Testfahrten durch den Umgebungssensor US oder lediglich durch den Datenverarbeitungsalgorithmus des Umgebungssensors US erzeugten Sensordaten beruht 303.

Das Simulationsmodell entspricht vorzugsweise jeweils einem der verschiedenen Simulationsmodell, welche mittels der Verfahren des ersten und des dritten Aspekts der Erfindung erzeugt werden können.

Die mittels des Simulationsmodells bestimmten Sensordaten werden schließlich über eine Datenschnittstelle 34 ausgegeben 304.

Die mittels eines erfindungsgemäßen Simulationsmodells simulierten Sensordaten eignen sich insbesondere für eine sogenannte Sensor-Fusion zum Testen eines Fahrerassistenzsystems oder aber auch eines Fahrzeugs.

Hierbei werden die simulierten Sensordaten des Umgebungssensors US mit weiteren Sensordaten weiterer simulierter Umgebungssensoren oder auch realer Ausgaben realer Sensoren zusammengeführt, um das Fahrerassistenzsystem bzw. das Fahrzeug in verschiedenen Entwicklungsstadien unter möglichst realen Bedingungen testen zu können.

Es wird darauf hingewiesen, dass es sich bei den Ausführungsbeispielen lediglich um Beispiele handelt, die den Schutzbereich, die Anwendungen und den Aufbau in keiner Weise einschränken sollen. Vielmehr wird dem Fachmann durch die vorausgehende Beschreibung ein Leitfaden für die Umsetzung von mindestens eines Ausführungsbeispiels gegeben, wobei diverse Änderungen, insbesondere in Hinblick auf die Funktion und Anordnung der beschriebenen Bestandteile, vorgenommen werden können, ohne den Schutzbereich zu verlassen, wie er sich aus den Ansprüchen und diesen äquivalenten Merkmalskombinationen ergibt.

## Patentansprüche

1. Computergestütztes Verfahren (100) zum Trainieren eines künstlichen neuronalen Netzes (KNN) zur Simulation des Verhaltens eines Umgebungssensors (US) eines Fahrerassistenzsystems in Verkehrsszenarien, folgende Arbeitsschritte aufweisend:
Einlesen (101) an einer Schnittstelle von Verkehrsszenarien einer Testfahrt (R);
Ableiten (102) mittels Verarbeitung durch einen Datenverarbeitungsalgorithmus und/oder einen Objekterkennungsalgorithmus von Testfahrtdaten und der von dem Umgebungssensor (US), insbesondere einer Kamera, auszugebenden Sensordaten, insbesondere einer Objektliste, aus den Verkehrsszenarien;
Erzeugen (103) eines Datenstroms mittels einer hard- und/oder softwaretechnischen Verarbeitungseinheit, insbesondere eines Bildstroms, welcher die Verkehrsszenarien aus der Perspektive des Umgebungssensors (US) abbildet;
Ausgeben (105; 105') des Datenstroms an einer Schnittstelle in der Weise, dass der Umgebungssensor (US) auf der Grundlage des Datenstroms Sensordaten erzeugen kann und an einer Datenschnittstelle (15) bereitstellen kann, an welcher auch die Testfahrtdaten und die auszugebenden Sensordaten bereitgestellt werden; und
Einlesen (106) der bereitgestellten Daten zum Trainieren in das künstliche neuronale Netz (KNN).

2. Computergestütztes Verfahren (200) zur Analyse eines Umgebungssensors (US) eines Fahrerassistenzsystems, folgende Arbeitsschritte aufweisend:
Einlesen (201) an einer Schnittstelle von Verkehrsszenarien einer Vielzahl von Testfahrten (R);
Ableiten (202) mittels Verarbeitung durch einen Datenverarbeitungsalgorithmus und/oder einen Objekterkennungsalgorithmus von Testfahrtdaten und der von dem Umgebungssensor (US) auszugebenden Sensordaten aus den Verkehrsszenarien;
Erzeugen (203) eines Datenstroms mittels einer hard- und/oder softwaretechnischen Verarbeitungseinheit, insbesondere eines Bildstroms, welcher die Verkehrsszenarien aus der Perspektive des Umgebungssensors (US) abbildet;
Ausgeben (205; 205') des Datenstroms an einer Schnittstelle an den Umgebungssensor (US), welcher auf der Grundlage des Datenstroms Sensordaten erzeugt; und
Anwenden (207) eines Simulationsmodells, welches auf einem künstlichen neuronalen Netz (KNN), das gemäß eines Verfahrens nach Anspruch 1 trainiert (206) wurde, basiert, wobei das Simulationsmodell eingerichtet ist, Sensordaten auf der Grundlage von einem Datenstrom einer beliebigen Testfahrt (R') zu simulieren und auszugeben.

3. Verfahren (100, 200) nach einem der vorhergehenden Ansprüche, wobei die Arbeitsschritte mit verschiedenen Testfahrten so lange wiederholt werden, bis das künstliche neuronale Netz (KNN) die Funktion des Umgebungssensors (US) möglichst genau abbildet, insbesondere bis die auszugebenden Sensordaten mit den ausgegebenen Sensordaten zu 95%, vorzugsweise 98% in Bezug auf eine nicht bei der Ausgleichsrechnung berücksichtigten Testfahrt (R') übereinstimmen.

4. Computergestütztes Verfahren (300) zur Simulation des Verhaltens eines Umgebungssensors (US), insbesondere einer Kamera, eines Fahrerassistenzsystems in Verkehrsszenarien, folgende Arbeitsschritte aufweisend:
Erfassen (302) eines Datenstroms mittels einer Schnittstelle, insbesondere eines Bildstroms, welcher eine Testfahrt (R') aus der Perspektive des Umgebungssensors (US) abbildet;
Bestimmen (303) von Sensordaten mittels eines Simulationsmodells des Umgebungssensors (US) auf der Grundlage des erfassten Datenstroms, wobei das Simulationsmodell eingerichtet ist, Sensordaten, insbesondere eine Objektliste, auf der Grundlage von einem Datenstrom einer beliebigen Testfahrt (R') zu simulieren und wobei das Simulationsmodell auf einem künstlichen neuronalen Netz (KNN), das gemäß eines Verfahrens nach Anspruch 1 trainiert wurde, beruht; und
Ausgeben (304) an einer Datenschnittstelle der mittels des Simulationsmodells bestimmten Sensordaten.

5. Verfahren nach einem der Ansprüche 2 bis 4, wobei die Sensordaten des Weiteren auf der Grundlage von Testfahrtdaten der zur Simulation eingesetzten Testfahrt (R') simuliert werden.

6. Verfahren (300) nach Anspruch 4 oder 5, des Weiteren den folgenden Arbeitsschritt aufweisend:
Erzeugen (301) eines Datenstroms, insbesondere eines Bildstroms, welcher eine Testfahrt (R'), insbesondere deren Verkehrsszenarien, aus der Perspektive des Umgebungssensors (US) abbildet.

7. Computergestütztes Verfahren zur Analyse eines Fahrerassistenzsystems, wobei das Fahrerassistenzsystem während einer realen oder simulierten Testfahrt mit den mittels eines Verfahrens (200, 300) nach einem der Ansprüche 2 bis 6 ausgegebenen Sensordaten, sowie mit Daten anderer virtueller oder realer Sensoren, welche vorzugsweise innerhalb eines Datennetzwerks, insbesondere CAN-Netzwerks, eines Fahrzeugs zur Verfügung stehen, gespeist wird.

8. Verfahren (100, 200, 300) nach einem der vorhergehenden Ansprüche, des Weiteren den folgenden Arbeitsschritt aufweisend:
Verschlechtern (104-1, 104-2; 204-1, 204-2), insbesondere Verzerren, des Datenstroms, insbesondere des Bildstroms, wobei vorzugsweise Witterungsbedingungen und/oder Mängel der Hardware des Umgebungssensors (US) berücksichtigt werden.

9. Verfahren (100, 200, 300) nach einem der vorhergehenden Ansprüche, wobei die Testfahrt oder die Testfahrten auf einem Prüfstand oder modellbasiert simuliert oder real durchgeführt wird, vorzugsweise mittels einer Kombination aus den vorgenannten Möglichkeiten.

10. System (10) zum Trainieren eines künstlichen neuronalen Netzes (KNN) zur Simulation eines Umgebungssensors (US) eines Fahrerassistenzsystems, aufweisend:
eine Schnittstelle (11) zum Einlesen von Verkehrsszenarien einer Testfahrt (R);
Mittel (12) zum Ableiten mittels Verarbeitung durch einen Datenverarbeitungsalgorithmus und/oder einen Objekterkennungsalgorithmus von Testfahrtdaten und der von dem Umgebungssensor (US) auszugebenden Sensordaten aus den Verkehrsszenarien;
Mittel (13), insbesondere eine Grafikkarte, zum Erzeugen eines Datenstroms, insbesondere eines Bildstroms, welcher die Verkehrsszenarien aus der Perspektive des Umgebungssensors (US) abbildet;
eine Schnittstelle (14), insbesondere ein Display, zum Ausgeben des Datenstroms in der Weise, dass der Umgebungssensor (US) auf der Grundlage des Datenstroms Sensordaten erzeugen kann; und
eine Datenschnittstelle (15) an welcher die erzeugten Sensordaten, die Testfahrtdaten und die auszugebenden Sensordaten dem künstlichen neuronalen Netz (KNN) bereitgestellt werden können.

11. System (20) zur Analyse eines Umgebungssensors (US) eines Fahrerassistenzsystems, aufweisend:
eine Schnittstelle (21) zum Einlesen von Verkehrsszenarien einer Vielzahl von Testfahrten (R);
Mittel (22) zum Ableiten mittels Verarbeitung durch einen Datenverarbeitungsalgorithmus und/oder einen Objekterkennungsalgorithmus von Testfahrtdaten und der von dem Umgebungssensor (US) auszugebenden Sensordaten aus den Verkehrsszenarien;
Mittel (23), insbesondere eine Grafikkarte, zum Erzeugen eines Datenstroms, insbesondere eines Bildstroms, welcher die Verkehrsszenarien aus der Perspektive des Umgebungssensors (US) abbildet;
eine Schnittstelle (24, 24'), insbesondere ein Display, zum Ausgeben des Datenstroms an den Umgebungssensor (US), welcher auf der Grundlage des Datenstroms Sensordaten erzeugt;
Mittel (26) zum Bestimmen von Sensordaten mittels eines Simulationsmodells, welches auf einem künstlichen neuronalen Netz, welches gemäß eines Verfahrens nach Anspruch 1 trainiert wurde, basiert, wobei das Simulationsmodell eingerichtet ist, Sensordaten auf der Grundlage von einem Datenstrom, insbesondere Bildstrom, einer beliebigen Testfahrt (R') zu simulieren; und
eine Datenschnittstelle (27) zum Ausgeben der mittels des Simulationsmodells bestimmten Sensordaten.

12. System (30) zur Simulation eines Umgebungssensors (US) eines Fahrerassistenzsystems, aufweisend:
eine Schnittstelle (32), insbesondere eine Kamera US oder eine Datenschnittstelle, zum Erfassen eines Datenstroms, welcher eine Testfahrt (R') aus der Perspektive des Umgebungssensors (US) abbildet;
Mittel (33) zum Bestimmen von Sensordaten mittels eines Simulationsmodells, welches eingerichtet ist, Sensordaten auf der Grundlage von einem Datenstrom einer beliebigen Testfahrt (R') zu simulieren, wobei das Simulationsmodell auf einem künstlichen neuronalen Netz (KNN), welches gemäß eines Verfahrens nach Anspruch 1 trainiert wurde, beruht; und
eine Datenschnittstelle (34) zum Ausgeben der mittels des Simulationsmodells bestimmten Sensordaten.

## Claims

1. Computer-implemented method (100) for training an artificial neural network (KNN) for simulating the behavior of an environment sensor (US) of a driver assistance system in traffic scenarios, comprising the following steps:
reading (101) traffic scenarios of a test drive (R) at an interface;
deriving (102) from the traffic scenarios test driving data and the sensor data, in particular an object list, to be output by the environment sensor (US), in particular a camera, by means of processing by a data processing algorithm and/or an object recognition algorithm;
generating (103) a data stream, in particular an image stream, which depicts the traffic scenarios from the perspective of the environment sensor (US) by means of a hardware and/or software processing unit;
outputting (105; 105') the data stream at an interface in such a way that the environment sensor (US) can generate sensor data on the basis of the data stream and
provide it at a data interface (15) at which the test drive data and the sensor data to be output are also provided; and
reading (106) the provided data into the artificial neural network (KNN) for training.

2. Computer-implemented method (200) for analyzing an environment sensor (US) of a driver assistance system, comprising the following steps:
reading (201) traffic scenarios of a variety of test drives (R) at an interface;
deriving (202) test driving data and the sensor data to be output by the environment sensor (US) from the traffic scenarios by means of processing by a data processing algorithm and/or an object recognition algorithm;
generating (203) a data stream, in particular an image stream, which depicts the traffic scenarios from the perspective of the environment sensor (US) by means of a hardware and/or software processing unit;
outputting (205; 205') the data stream at an interface to the environmental sensor (US), which generates sensor data based on the data stream; and
applying (207) a simulation model based on an artificial neural network (KNN) trained (206) according to a method according to claim 1, wherein the simulation model is arranged to simulate and output sensor data based on a data stream of any test drive (R').

3. Method (100, 200) according to any one of the preceding claims, wherein the operating steps are repeated with different test runs until the artificial neural network (KNN) maps the function of the ambient sensor (US) as accurately as possible, in particular until the sensor data to be output matches the output sensor data to 95%, preferably 98%, with respect to a test run (R') not taken into account in the compensation calculation.

4. Computer-implemented method (300) for simulating the behavior of an environment sensor (US), in particular a camera, of a driver assistance system in traffic scenarios, comprising the following operating steps:
capturing (302) of a data stream by means of an interface, in particular an image stream, which depicts a test drive (R') from the perspective of the ambient sensor (US);
determining (303) sensor data by means of a simulation model of the environment sensor (US) on the basis of the acquired data stream, wherein the simulation model is adapted to simulate sensor data, in particular an object list, on the basis of a data stream of an arbitrary test drive (R') and wherein the simulation model is based on an artificial neural network (KNN) trained according to a method according to claim 1; and
outputting (304) the sensor data determined using the simulation model at a data interface.

5. The method of any one of claims 2 to 4, wherein the sensor data is further simulated based on test drive data of the test drive (R') used for simulation.

6. The method (300) according to claim 4 or 5, further comprising the following step:
Generating (301) a data stream, in particular an image stream, which depicts a test drive (R'), in particular its traffic scenarios, from the perspective of the environment sensor (US).

7. Computer-implemented method for analyzing a driver assistance system, wherein the driver assistance system is fed during a real or simulated test drive with the sensor data output by means of a method (200, 300) according to one of claims 2 to 6, as well as with data from other virtual or real sensors, which are preferably available within a data network, in particular CAN network, of a vehicle.

8. A method (100, 200, 300) according to any one of the preceding claims, further comprising the following step:
degrading (104-1, 104-2; 204-1, 204-2), in particular distorting, the data stream, in particular the image stream, preferably taking into account weather conditions and/or defects of the hardware of the environmental sensor (US).

9. Method (100, 200, 300) according to any one of the preceding claims, wherein the test drive or test drives are simulated on a test bench or model-based or performed in reality, preferably by means of a combination of the aforementioned possibilities.

10. A system (10) for training an artificial neural network (KNN) for simulating an environment sensor (US) of a driver assistance system, comprising:
an interface (11) for reading in traffic scenarios of a test drive (R);
means (12) for deriving, test driving data and the sensor data to be output by the environment sensor (US) from the traffic scenarios by means of processing by a data processing algorithm and/or an object recognition algorithm;
means (13), in particular a graphics card, for generating a data stream, in particular an image stream, which depicts the traffic scenarios from the perspective of the environment sensor (US);
an interface (14), in particular a display, for outputting the data stream in such a way that the environmental sensor (US) can generate sensor data based on the data stream; and
a data interface (15) at which the generated sensor data, the test drive data and the sensor data to be output can be provided to the artificial neural network (KNN).

11. System (20) for analyzing an environment sensor (US) of a driver assistance system, comprising:
an interface (21) for reading traffic scenarios of a plurality of test drives (R);
means (22) for deriving, by means of processing by a data processing algorithm and/or an object recognition algorithm, test driving data and the sensor data to be output by the environment sensor (US) from the traffic scenarios;
means (23), in particular a graphics card, for generating a data stream, in particular an image stream, which depicts the traffic scenarios from the perspective of the environment sensor (US);
an interface (24, 24'), in particular a display, for outputting the data stream to the environmental sensor (US), which generates sensor data based on the data stream;
means (26) for determining sensor data by means of a simulation model based on an artificial neural network trained according to a method according to claim 1,
wherein the simulation model is arranged to simulate sensor data on the basis of a data stream, in particular image stream, of an arbitrary test drive (R'); and
a data interface (27) for outputting the sensor data determined by means of the simulation model.

12. System (30) for simulating an environment sensor (US) of a driver assistance system, comprising:
an interface (32), in particular a camera (US) or a data interface, for capturing a data stream that images a test drive (R') from the perspective of the environment sensor (US);
means (33) for determining sensor data by means of a simulation model arranged to simulate sensor data on the basis of a data stream of any test drive (R'), the simulation model being based on an artificial neural network (KNN) trained according to a method according to claim 1; and
a data interface (34) for outputting the sensor data determined by means of the simulation model.

## Revendications

1. Procédé assisté par ordinateur (100) pour entraîner un réseau neuronal artificiel (RNA) pour simuler le comportement d'un capteur d'environnement (CE) d'un système d'assistance au conducteur dans des scénarii de trafic routier, présentant des étapes de travail suivantes :
la lecture (101) sur une interface de scénarii de trafic routier d'un trajet test (R) ;
la déduction (102) à partir des scénarii de trafic routier, au moyen du traitement par un algorithme de traitement de données et/ou un algorithme de reconnaissance d'objet, de données de trajet test et des données de capteur, à envoyer par le capteur d'environnement (CE), en particulier une caméra, en particulier d'une liste d'objets ;
la génération (103) d'un flux de données au moyen d'une unité de traitement technique de matériel et/ou de logiciel, en particulier d'un flux d'images, lequel reproduit les scénarii de trafic routier à partir de la perspective du capteur d'environnement (CE) ;
l'envoi (105 ; 105') du flux de données sur une interface de telle manière que le capteur d'environnement (CE) peut produire sur la base du flux de données des données de capteur et peut les fournir sur une interface de données (15), sur laquelle les données de trafic routier et les données de capteur à envoyer sont également fournies ; et
la lecture (106) des données fournies pour l'entraînement dans le réseau neuronal artificiel (RNA).

2. Procédé assisté par ordinateur (200) pour analyser un capteur d'environnement (CE) d'un système d'assistance au conducteur, présentant des étapes de travail suivantes :
la lecture (201) sur une interface de scénarii de trafic routier d'une pluralité de trajets tests (R) ;
la déduction (202) à partir des scénarii de trafic routier, au moyen du traitement par un algorithme de traitement de données et/ou un algorithme de reconnaissance d'objet, de données de trajet test et des données de capteur à envoyer par le capteur d'environnement (CE) ;
la génération (203) d'un flux de données au moyen d'une unité de traitement technique de matériel et/ou de logiciel, en particulier d'un flux d'images, lequel reproduit les scénarii de trafic routier à partir de la perspective du capteur d'environnement (CE) ;
l'envoi (205 ; 205') du flux de données sur une interface au capteur d'environnement (CE), lequel produit des données de capteur sur la base du flux de données ; et
l'application (207) d'un modèle de simulation, lequel se base sur un réseau neuronal artificiel (RNA), qui a été entraîné (206) selon un procédé selon la revendication 1, dans lequel le modèle de simulation est mis au point pour simuler et envoyer des données de capteur sur la base d'un flux de données d'un trajet test quelconque (R').

3. Procédé (100, 200) selon l'une quelconque des revendications précédentes, dans lequel les étapes de travail sont répétées avec différents trajets tests jusqu'à ce que le réseau neuronal artificiel (RNA) reproduise précisément dans la mesure du possible le fonctionnement du capteur d'environnement (CE), en particulier jusqu'à ce que les données de capteur à envoyer concordent avec les données de capteur envoyées à hauteur de 95 %, de préférence 98 %, par rapport à un trajet test (R') non pris en compte lors du calcul de la compensation.

4. Procédé assisté par ordinateur (300) pour simuler le comportement d'un capteur d'environnement (CE), en particulier d'une caméra, d'un système d'assistance au conducteur dans des scénarii de trafic routier, présentant des étapes de travail suivantes :
la détection (302) d'un flux de données au moyen d'une interface, en particulier d'un flux d'images, lequel reproduit un trajet test (R') à partir de la perspective du capteur d'environnement (CE) ;
la définition (303) de données de capteur au moyen d'un modèle de simulation du capteur d'environnement (CE) sur la base du flux de données détecté, dans lequel le modèle de simulation est mis au point pour simuler des données de capteur, en particulier d'une liste d'objets, sur la base d'un flux de données d'un trajet test quelconque (R') et
dans lequel le modèle de simulation repose sur un réseau neuronal artificiel (RNA), qui a été entraîné selon un procédé selon la revendication 1 ; et
l'envoi (304) à une interface de données des données de capteur définies au moyen du modèle de simulation.

5. Procédé selon l'une quelconque des revendications 2 à 4, dans lequel les données de capteur sont simulées par ailleurs sur la base de données de trajet test du trajet test (R') utilisé pour la simulation.

6. Procédé (300) selon la revendication 4 ou 5, présentant par ailleurs l'étape de travail suivante :
la production (301) d'un flux de données, en particulier d'un flux d'images, lequel reproduit un trajet test (R'), en particulier ses scénarii de trafic routier, à partir de la perspective du capteur d'environnement (CE).

7. Procédé assisté par ordinateur pour analyser un système d'assistance au conducteur, dans lequel le système d'assistance au conducteur est alimenté au cours d'un trajet test réel ou simulé avec des données de capteur envoyées au moyen d'un procédé (200, 300) selon l'une quelconque des revendications 2 à 6, ainsi qu'avec des données d'autres capteurs virtuels ou réels, lesquels sont à disposition de préférence dans un réseau de données, en particulier un réseau CAN, d'un véhicule.

8. Procédé (100, 200, 300) selon l'une quelconque des revendications précédentes, présentant par ailleurs l'étape de travail suivante :
la dégradation (104-1, 104-2 ; 204-1, 204-2), en particulier la déformation, du flux de données, en particulier du flux d'images, dans lequel de préférence des conditions météorologiques et/ou des défaillances du matériel du capteur d'environnement (CE) sont prises en compte.

9. Procédé (100, 200, 300) selon l'une quelconque des revendications précédentes, dans lequel le trajet test ou les trajets tests sont simulés sur un banc d'essai ou sur la base d'un modèle ou sont réellement effectués, de préférence au moyen d'une combinaison composée des possibilités susmentionnées.

10. Système (10) pour entraîner un réseau neuronal artificiel (RNA) pour simuler un capteur d'environnement (CE) d'un système d'assistance de conducteur, présentant :
une interface (11) pour lire des scénarii de trafic routier d'un trajet test (R) ;
des moyens (12) pour déduire à partir des scénarii de trafic routier, au moyen du traitement par un algorithme de traitement de données et/ou un algorithme de reconnaissance d'objet, des données de trajet test et des données de capteur, à envoyer par le capteur d'environnement (CE) ;
des moyens (13), en particulier une carte graphique, pour générer un flux de données, en particulier un flux d'images,
lequel reproduit les scénarii de trafic routier à partir de la perspective du capteur d'environnement (CE) ;
une interface (14), en particulier un écran, pour envoyer le flux de données de telle manière que le capteur d'environnement (CE) peut produire des données de capteur sur la base du flux de données ; et
une interface de données (15), sur laquelle les données de capteur produites, les données de trajet test et les données de capteur à envoyer peuvent être fournies au réseau neuronal artificiel (RNA).

11. Système (20) pour analyser un capteur d'environnement (CE) d'un système d'assistance au conducteur, présentant :
une interface (21) pour lire des scénarii de trafic routier d'une pluralité de trajets tests (R) ;
des moyens (22) pour déduire à partir des scénarii de trafic routier, au moyen du traitement par un algorithme de traitement de données et/ou d'un algorithme de reconnaissance d'objet, des données de trajet test et des données de capteur à envoyer par le capteur d'environnement (CE) ;
des moyens (23), en particulier une carte graphique, pour produire un flux de données, en particulier un flux d'images, lequel reproduit les scénarii de trajet routier à partir de la perspective du capteur d'environnement (CE) ;
une interface (24, 24'), en particulier un écran, pour envoyer le flux de données au capteur d'environnement (CE),
lequel produit des données de capteur sur la base du flux de données ;
des moyens (26) pour définir des données de capteur au moyen d'un modèle de simulation, laquelle se base sur un réseau neuronal artificiel, lequel a été entraîné selon un procédé selon la revendication 1, dans lequel le modèle de simulation est mis au point pour simuler des données de capteur sur la base d'un flux de données, en particulier un flux d'images, d'un trajet test quelconque (R') ; et
une interface de données (27) pour envoyer les données de capteur définies au moyen du modèle de simulation.

12. Système (30) pour la simulation d'un capteur d'environnement (CE) d'un système d'assistance au conducteur, présentant :
une interface (32), en particulier un caméra US ou une interface de données, pour détecter un flux de données,
lequel reproduit un trajet test (R') à partir de la perspective du capteur d'environnement (CE) ;
des moyens (33) pour définir des données de capteur au moyen d'un modèle de simulation, lequel est mis au point pour simuler des données de capteur sur la base d'un flux de données d'un trajet test quelconque (R'), dans lequel le modèle de simulation repose sur un réseau neuronal artificiel (RNA), lequel a été entraîné selon un procédé selon la revendication 1 ; et
une interface de données (34) pour envoyer des données de capteur définies au moyen du modèle de simulation.
